# EUROPEAN PATENT APPLICATION

(11) **EP 4 383 352 A1**
(43) Date of publication of application: **12.06.2024**
(21) Application number: 22909541.9
(22) Date of filing: 03.11.2022
(51) Int. Cl.: H01L 31/04

(54) **SOLAR CELL AND MANUFACTURING METHOD THEREFOR, PHOTOVOLTAIC MODULE, AND ELECTRICAL DEVICE**

(30) Priority: 24.12.2021 CN 202111603126
(71) Applicant: Contemporary Amperex Technology Co., Limited, Ningde, Fujian 352100 (CN)
(72) Inventor: CHEN, Guodong, Ningde, Fujian 352100 (CN); LIN, Weile, Ningde, Fujian 352100 (CN); LIU, Zhaohui, Ningde, Fujian 352100 (CN); WANG, Yandong, Ningde, Fujian 352100 (CN); GUO, Wenming, Ningde, Fujian 352100 (CN); GUO, Yongsheng, Ningde, Fujian 352100 (CN); SU, Shuojian, Ningde, Fujian 352100 (CN); CHEN, Changsong, Ningde, Fujian 352100 (CN); OUYANG, Chuying, Ningde, Fujian 352100 (CN)
(74) Representative: Holt, Lucy Rose
(86) International application number: PCT/CN2022/129470
(87) International publication number: WO 2023/116224

(57) **Abstract**

The present application relates to a solar cell and a manufacturing method therefor, a photovoltaic module, and an electrical device. The solar cell comprises: a plurality of sub-cells, the plurality of sub-cells being electrically connected; dead zones, provided between two adjacent sub-cells; a light reflecting portion, provided on at least some of the surfaces of the dead zones and configured to reflect incident light irradiated on the dead zones; and a packaging assembly, provided on one side of the light reflecting portion distant from the dead zones, and configured to reflect the incident light reflected by the light reflecting portion to the surfaces of the sub-cells, so as to convert the incident light into electrical energy. The solar cell in embodiments of the present application can effectively improve the photoelectric conversion efficiency of the solar cell.

## Description

### CROSS-REFERENCE TO RELATED APPLICATIONS

This application claims priority to Chinese Patent Application No. 202111603126.4, filed on December 24, 2021 and entitled "SOLAR CELL AND MANUFACTURING METHOD THEREOF, PHOTOVOLTAIC MODULE, AND ELECTRICAL DEVICE", which is incorporated herein by reference in its entirety.

### TECHNICAL FIELD

This application relates to the technical field of battery production, and in particular, to a solar cell and a manufacturing method thereof, a photovoltaic module, and an electrical device.

### BACKGROUND

A solar cell is a photovoltaic conversion device that directly converts optical energy into electrical energy, possesses excellent photovoltaic properties, and can be prepared in a simple method, thereby bringing new space and hope for photovoltaic power generation.

In a production process of solar cells, how to further improve the photovoltaic conversion efficiency is an urgent problem.

### SUMMARY

This application provides a solar cell and a manufacturing method thereof, a photovoltaic module, and an electrical device to improve the photovoltaic conversion efficiency of the solar cell.

According to a first aspect, an embodiment of this application provides a solar cell. The solar cell includes: a plurality of sub-cells, where the plurality of sub-cells are electrically connected to each other; a dead zone, disposed between two adjacent sub-cells; a reflection portion, disposed on at least a part of surfaces of the dead zone, and configured to reflect incident light radiated on the dead zone; a packaging component, disposed on a side of the reflection portion away from the dead zone, and configured to reflect the incident light, which is reflected by the reflection portion, to a surface of the sub-cell to convert the incident light into electrical energy.

In the above technical solution, the reflection portion is disposed on at least a part of the surfaces of the dead zone. The incident light radiated onto the dead zone is reflected to the packaging component by the reflection portion, and then the packaging component reflects the incident light to the surface of the sub-cell. In this way, the sub-cell can perform photovoltaic conversion by using such light, thereby improving the photovoltaic conversion efficiency of the solar cell.

In some embodiments, the reflection portion covers all surfaces, oriented toward the packaging component, of the dead zone. In these embodiments of this application, the reflection portion covers all surfaces, oriented toward the packaging component, of the dead zone, so that the incident light radiated onto the dead zone can be reflected by the reflection portion. The incident light radiated on the dead zone is utilized sufficiently, thereby further improving the light utilization rate of the solar cell.

In some embodiments, the reflection portion includes a curved convex surface protruding away from the dead zone. In these embodiments of this application, the curved convex surface can increase light divergence rate, so that the incident light is reflected to the packaging component along different reflection paths, thereby reducing the amount of the incident light that is reflected back to the dead zone after being reflected by the packaging component.

In some embodiments, the sub-cell includes two end portions disposed opposite to each other. The dead zone includes a main portion and a recessed portion. The main portion connects the end portions of the two adjacent sub-cells. The recessed portion is formed by recessing the dead zone relative to the main portion. The reflection portion is disposed on the main portion and/or the recessed portion. In these embodiment of this application, the reflection portion is disposed on the main portion and/or the recessed portion, and can effectively reflect the incident light radiated to the dead zone.

In some embodiments, the reflection portion includes a body portion and an extension portion. The body portion is disposed in the recessed portion. The extension portion protrudes from a surface of the main portion, the surface being oriented toward the packaging component. In these embodiments of this application, the body portion is disposed in the recessed portion, and can obstruct external moisture and oxygen from intruding into the sub-cell. The extension portion protrudes from the main portion, and can increase the area for receiving incident light, thereby improving the utilization rate of light.

In some embodiments, a part of the extension portion is located on the surface of the main portion, the surface being oriented toward the packaging component. In these embodiments of this application, the area capable of reflecting the incident light is further increased, thereby further improving the utilization rate of light.

In some embodiments, the main portion includes: a first electrode layer; a photovoltaic conversion component, including a first photovoltaic portion and a second photovoltaic portion, where the first photovoltaic portion is located on a surface of the first electrode layer, and the second photovoltaic portion connects the first photovoltaic portion and the first electrode layer; and a second electrode layer, including a first electrode portion and a second electrode portion, where the first electrode portion is located on a surface of the first photovoltaic portion, the surface being oriented back from the first electrode layer, the second electrode portion connects the first electrode portion and the first electrode layer, and the recessed portion runs through at least the first electrode portion. This form of structure simplifies the preparation process and is cost-effective.

In some embodiments, the photovoltaic conversion component includes a photovoltaic conversion layer. The photovoltaic conversion layer is located at least between the first electrode layer and the second electrode layer. The photovoltaic conversion component further includes an electron transport layer, and the electron transport layer is located between the photovoltaic conversion layer and the second electrode layer; and/or the photovoltaic conversion component further includes a hole transport layer, and the hole transport layer is located between the photovoltaic conversion layer and the first electrode layer. In these embodiments of this application, the electron transport layer and/or the hole transport layer are disposed, and can reduce recombination of holes and electrons, and improve the photovoltaic conversion efficiency.

According to a second aspect, an embodiment of this application further provides a photovoltaic module, including the solar cell according to an embodiment in the first aspect of this application.

According to a third aspect, an embodiment of this application further provides an electrical device, including the photovoltaic module according to an embodiment in the second aspect of this application.

According to a fourth aspect, an embodiment of this application further provides a solar cell manufacturing method. The method includes: providing a plurality of sub-cells, where the sub-cells are electrically connected to each other, and a dead zone is disposed between two adjacent sub-cells; providing a reflection portion, disposed on at least a part of surfaces of the dead zone; and providing a packaging component, disposed on a side of the reflection portion away from the dead zone.

In the solar cell prepared by the manufacturing method according to this embodiment of this application, a reflection portion and a packaging component are disposed, so that the incident light radiated onto the dead zone can be radiated onto the sub-cell after being reflected. In this way, the sub-cell can perform photovoltaic conversion by using such light, thereby improving the photovoltaic conversion efficiency of the solar cell.

In some embodiments, providing a reflection portion disposed on at least a part of surfaces of the dead zone includes: applying the reflection portion onto at least a part of surfaces of the dead zone by filling or coating. The manufacturing method is relatively simple.

### BRIEF DESCRIPTION OF DRAWINGS

To describe the technical solutions of some embodiments of this application more clearly, the following outlines the drawings used in the embodiments of this application. Evidently, the drawings outlined below are merely a part of embodiments of this application. A person of ordinary skill in the art may derive other drawings from the outlined drawings without making any creative efforts.
FIG. 1 is a schematic structural diagram of a vehicle according to some embodiments of this application;
FIG. 2 is a schematic block diagram of a photovoltaic module according to some embodiments of this application;
FIG. 3 is a schematic structural diagram of a solar cell according to some embodiments of this application;
FIG. 4 is a close-up view of a dead zone of the solar cell shown in FIG. 3;
FIG. 5 is a close-up view of a dead zone and a reflection portion of the solar cell shown in FIG. 3;
FIG. 6 is a schematic structural diagram of a solar cell according to some other embodiments of this application;
FIG. 7 is a close-up view of a dead zone and a reflection portion of the solar cell shown in FIG. 6;
FIG. 8 is another close-up view of a dead zone and a reflection portion of the solar cell shown in FIG. 6;
FIG. 9 is a schematic structural diagram of a solar cell according to still some other embodiments of this application;
FIG. 10 is a close-up view of a dead zone and a reflection portion of the solar cell shown in FIG. 9;
FIG. 11 is a schematic flowchart of a solar cell manufacturing method according to some embodiments of this application; and
FIG. 12 is a schematic flowchart of a solar cell manufacturing method according to some other embodiments of this application.

The drawings are not necessarily drawn to scale.

### List of reference numerals:

X. thickness direction; Y first direction; P1. first hollowed portion; P2. second hollowed portion; P3. third hollowed portion;
1. vehicle; 2. photovoltaic module; 3. controller; 4. motor;
5. solar cell;
50. substrate;
51. first electrode layer;
52. photovoltaic conversion component; 521. hole transport layer; 522. photovoltaic conversion layer; 523. electron transport layer;
53. second electrode layer;
54. reflection portion; 541. curved convex surface; 542. body portion; 543. extension portion;
55. packaging component; 551. adhesive film; 552. cover plate;
6. sub-cell; 61. end portion;
7. dead zone; 71. main portion; 711. first photovoltaic portion; 712. second photovoltaic portion; 713. first electrode portion; 714. second electrode portion; 72. recessed portion.

### DETAILED DESCRIPTION OF EMBODIMENTS

To make the objectives, technical solutions, and advantages of the embodiments of this application clearer, the following gives a clear description of the technical solutions in the embodiments of this application with reference to the drawings in the embodiments of this application. Evidently, the described embodiments are merely a part of but not all of the embodiments of this application. All other embodiments derived by a person of ordinary skill in the art based on the embodiments of this application without making any creative efforts still fall within the protection scope of this application.

Unless otherwise defined, all technical and scientific terms used herein have the same meanings as what is normally understood by a person skilled in the technical field of this application. The terms used in the specification of this application are merely intended to describe specific embodiments but not intended to limit this application. The terms "include" and "contain" and any variations thereof used in the specification, claims, and brief description of drawings of this application are intended as non-exclusive inclusion. The terms such as "first" and "second" used in the specification, claims, and brief description of drawings herein are intended to distinguish between different items, but are not intended to describe a specific sequence or order of precedence.

Reference to "embodiment" in this application means that a specific feature, structure or characteristic described with reference to the embodiment may be included in at least one embodiment of this application. Reference to this term in different places in the specification does not necessarily represent the same embodiment, nor does it represent an independent or alternative embodiment in a mutually exclusive relationship with other embodiments.

In the description of this application, unless otherwise expressly specified and defined, the terms "mount", "concatenate", "connect", and "attach" are understood in a broad sense. For example, a "connection" may be a fixed connection, a detachable connection, or an integrated connection; or may be a direct connection or an indirect connection implemented through an intermediary; or may be internal communication between two components. A person of ordinary skill in the art is able to understand the specific meanings of the terms in this application according to specific situations.

The term "and/or" in this application indicates merely a relation for describing the related items, and represents three possible relationships. For example, "A and/or B" may represent the following three circumstances: A alone, both A and B, and B alone. In addition, the character "/" herein generally indicates an "or" relationship between the item preceding the character and the item following the character.

In embodiments of this application, the same reference numeral denotes the same component. For brevity, detailed descriptions of the same component are omitted in a different embodiment. Understandably, dimensions such as thickness, length, and width of various components in the embodiments of this application shown in the drawings, and dimensions such as overall thickness, length, and width of an integrated device are merely illustrative descriptions, but do not constitute any limitation on this application.

"A plurality of' referred to in this application means two or more (including two).

In an embodiment of this application, a solar cell is a photovoltaic conversion device that directly converts optical energy into electrical energy based on the theory of photovoltaic effect. Different materials are used in the photovoltaic conversion device, and the quasi-Fermi energy level varies between different materials, thereby forming a built-in electric field inside the photovoltaic conversion device. Under illumination, photons with higher energy are absorbed, and photocarriers (electron-hole pairs) are excited. With different types of charges, electrons and holes drift in opposite directions under the action of the built-in electric field. The electrons move toward a negative electrode, and the holes move toward a positive electrode, thereby forming a potential difference between the positive electrode and the negative electrode, and generating a current.

A large-area solar cell is etched to form a plurality of sub-cells to obtain the desired voltage and current output. For example, the solar cell is subjected to a first etch, a second etch, and a third etch by laser etching or mechanical etching, so as to segment the solar cell into sub-cells and electrically connect the sub-cells (for example, in series). A process flow of etching is as follows: forming a first electrode layer on a substrate; etching the first electrode layer to form a first hollowed portion to separate sub-cells; forming a photovoltaic conversion component on a side of the first electrode layer, the side being oriented back from the substrate; etching the photovoltaic conversion component to form a second hollowed portion to carve out channels through which the sub-cells are connected to each other in series; forming a second electrode layer on a side of the photovoltaic conversion component, the side being oriented back from the substrate; and etching the second electrode layer to form a third hollowed portion to segment the second electrode layer.

The solar cell includes a plurality of sub-cells and a plurality of dead zones. The dead zone is disposed between the two sub-cells, and is a region between the first hollowed portion and the third hollowed portion, and includes the first electrode layer, the photovoltaic conversion component, and the second electrode layer that are located in this region. The sub-cell includes an active region. The active region means a region in which light can be effectively utilized for performing photovoltaic conversion, such as a region in which photovoltaic conversion can be performed in each sub-cell. In the dead zone, the light cannot be utilized, thereby resulting in a waste of light.

In the field of solar cells, photovoltaic conversion efficiency is used to evaluate the performance of a solar cell. The higher the photovoltaic conversion efficiency, the higher the performance of the solar cell. The smaller the dead zone, the smaller the region in which the light cannot be utilized, thereby improving the photovoltaic conversion efficiency.

The inventor hereof finds that, a conventional method for improving the photovoltaic conversion efficiency is to reduce the area of the dead zone to reduce the loss of light in the dead zone. Due to limitation of the production process, the area of the dead zone is unable to be reduced infinitely, and the area of the dead zone is unable to be reduced significantly, and the photovoltaic conversion efficiency is unable to be improved significantly.

In view of the above problem, the inventor discloses a technical solution, in which a reflection portion is disposed on at least a part of surfaces of the dead zone and configured to reflect incident light radiated on the dead zone. A packaging component is disposed on a side of the reflection portion away from the dead zone, and configured to reflect the incident light, which is reflected by the reflection portion, to a surface of the sub-cell. The reflection portion and the packaging component can reflect the incident light radiated on the dead zone, and radiate the light onto the sub-cell to convert the incident light into electrical energy. The photovoltaic conversion efficiency of the solar cell of such a structure is enhanced significantly, and the reliability and stability of the solar cell are improved significantly.

The technical solution described in this embodiment of this application is applicable to a photovoltaic module containing a solar cell, and an electrical device that uses the photovoltaic module.

The electrical device may be a vehicle, a mobile phone, a portable device, a notebook computer, a ship, a spacecraft, an electric toy, a power tool, or the like. The vehicle may be an oil-fueled vehicle, a natural gas vehicle, or a new energy vehicle. The spacecraft includes an airplane, a rocket, a space shuttle, a spaceship, and the like. The electric toy includes a fixed or mobile electric toy, such as a game console, an electric car toy, an electric ship toy, an electric airplane toy, and the like. The electric tool includes an electrical metal cutting tool, an electrical grinding tool, an electrical assembling tool, and an electric tool for use in railways. Examples of the electric tool are an electrical drill, an electrical grinder, an electrical wrench, an electrical screwdriver, an electrical hammer, an electrical impact drill, a concrete vibrator, an electrical planer, and the like. The electrical device is not particularly limited in embodiments of this application.

For ease of description in the following embodiments, a vehicle is used as an example of the electrical device.

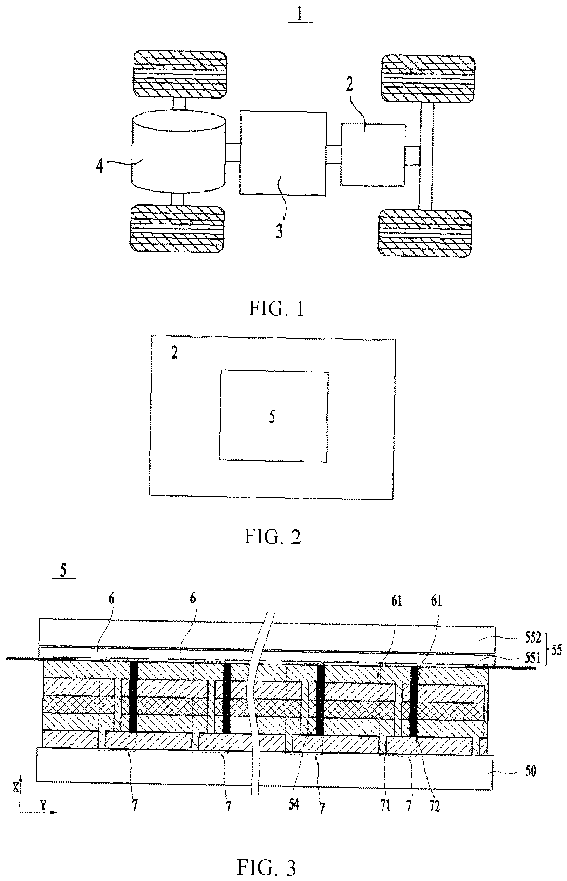

FIG. 1 is a schematic structural diagram of a vehicle according to some embodiments of this application. As shown in FIG. 1, a photovoltaic module 2 is disposed inside the vehicle 1. The photovoltaic module 2 may be disposed at the top, front, or rear of the vehicle 1. The photovoltaic module 2 may be configured to supply power to the vehicle 1. For example, the photovoltaic module 2 may serve as an operating power supply of the vehicle 1.

The vehicle 1 may further include a controller 3 and a motor 4. The controller 3 is configured to control the photovoltaic module 2 to supply power to the motor 4, for example, to meet electrical energy requirements in starting, navigating, or running the vehicle 1.

FIG. 2 is a schematic block diagram of a photovoltaic module according to some embodiments of this application. As shown in FIG. 2, the photovoltaic module 2 includes a solar cell 5. There may be one or more solar cells 5. If there are a plurality of solar cells 5, the plurality of solar cells 5 may be connected in series, parallel, or series-and-parallel pattern. The series-and-parallel pattern means that some of the solar cells 5 are connected in series and other solar cells are connected in parallel so as to provide relatively high voltage and capacity.

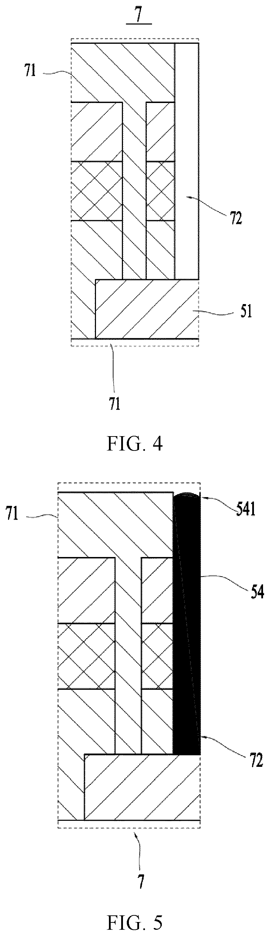

FIG. 3 is a schematic structural diagram of a solar cell according to some embodiments of this application; FIG. 4 is a close-up view of a dead zone of the solar cell shown in FIG. 3; and FIG. 5 is a close-up view of a dead zone and a reflection portion of the solar cell shown in FIG. 3.

As shown in FIG. 3 to FIG. 5, the solar cell 5 provided in an embodiment of this application includes a plurality of sub-cells 6, a dead zone 7, a reflection portion 54, and a packaging component 55. The plurality of sub-cells 6 are electrically connected to each other. The dead zone 7 is disposed between two adjacent sub-cells 6. The reflection portion 54 is disposed on at least a part of surfaces of the dead zone 7, and configured to reflect incident light radiated on the dead zone 7. The packaging component 55 is disposed on a side of the reflection portion 54 away from the dead zone 7, and configured to reflect the incident light, which is reflected by the reflection portion 54, to a surface of the sub-cell 6 to convert the incident light into electrical energy.

The solar cell 5 includes a plurality of sub-cells 6. The plurality of sub-cells 6 may be connected in series, parallel, or series-and-parallel pattern. The series-and-parallel pattern means a combination of series connection and parallel connection of the plurality of sub-cells 6. By segmenting the solar cell 5 into a plurality of sub-cells 6, the voltage, capacity, and other performance indicators of the solar cell 5 are improved.

Dead zones 7 are formed when the solar cell 5 is segmented into a plurality of sub-cells 6. Each dead zone 7 includes two surfaces opposite to each other along a thickness direction X of the solar cell 5. Of the two surfaces, one is oriented toward the packaging component 55, and the other is oriented back from packaging component 55. The region indicated by the reference numeral 7 in FIG. 3 represents a dead zone, and X represents the thickness direction.

The reflection portion 54 means a member that possesses reflective properties. In other words, when external light is incident on the reflection portion 54, the reflection portion 54 can reflect the incident light. To avoid a short circuit between two adjacent sub-cells 6, the reflection portion 54 also needs to be insulative to insulate the two adjacent sub-cells 6. Specifically, the reflection portion 54 may be made by applying a reflection layer onto the surface of an insulation member, or may be directly made of an insulative reflection material. As an example, the reflection layer and the reflection material may be made of at least one of reflection powder, titanium dioxide powder, glass microsphere powder, or insulative reflection filaments.

To dispose the reflection portion 54 on at least a part of the surfaces of the dead zone 7, the reflection portion 54 may be disposed on a part of the surfaces, oriented toward the packaging component 55, of the dead zone 7, or the reflection portion 54 may be disposed on all the surfaces, oriented toward the packaging component 55, of the dead zone 7.

The packaging component 55 is configured to package the sub-cell 6 and form a finished product. The packaging component 55 is reflective to some extent. When the reflection portion 54 reflects the incident light to the packaging component 55, the packaging component 55 further reflects the incident light, so that a part of the incident light is reflected to the surface of the sub-cell 6. In this way, the sub-cell 6 can continue to utilize this part of light, thereby improving the light utilization rate of the solar cell 5.

In some embodiments, the packaging component 55 may include an adhesive film 551 and a cover plate 552. The adhesive film 551 possesses bonding properties and can bond the photovoltaic conversion component of the sub-cell 6 to the cover plate 552. At least one of the adhesive film 551 or the cover plate 552 possesses reflection properties and can reflect light, thereby improving the light utilization rate. As an example, the adhesive film 551 may be an ethylene-vinyl acetate copolymer (Ethylene-vinyl Acetate Copolymer, EVA) adhesive film. The cover plate 552 may be a glass cover or the like. Optionally, the packaging component 55 may further include other members such as sealing element.

In this embodiment of this application, the reflection portion 54 is disposed on at least a part of the surfaces of the dead zone 7. The incident light radiated onto the dead zone 7 is reflected to the packaging component 55 by the reflection portion 54, and then the packaging component 55 reflects a part of the incident light to the surface of the sub-cell 6. In this way, the sub-cell 6 can perform photovoltaic conversion by using this part of light, thereby improving the photovoltaic conversion efficiency of the solar cell 5.

In some embodiments, the reflection portion 54 covers all surfaces, oriented toward the packaging component 55, of the dead zone 7, so that the incident light radiated onto the dead zone 7 can be reflected by the reflection portion 54. The incident light radiated on the dead zone 7 is utilized sufficiently, thereby further improving the light utilization rate of the solar cell 5.

The surface, oriented toward the packaging component 55, of the reflection portion 54 may be a flat face or a curved face, depending on the specific process requirements. This is not limited in an embodiment of this application.

Still referring to FIG. 3 to FIG. 5, in some embodiments, the reflection portion 54 includes a curved convex surface 541 protruding away from the dead zone 7. The curved convex surface 541 can increase light divergence rate, so that the incident light is reflected to the packaging component 55 along different reflection paths, thereby reducing the amount of the incident light that is reflected back to the dead zone 7 after being reflected by the packaging component 55.

Still referring to FIG. 3 to FIG. 5, in some embodiments, the sub-cell 6 includes two end portions 61 disposed opposite to each other. The dead zone 7 includes a main portion 71 and a recessed portion 72. The main portion 71 connects the end portions 61 of the two adjacent sub-cells 6. The recessed portion 72 is formed by recessing the dead zone relative to the main portion 71. The reflection portion 54 is disposed on the main portion 71 and/or the recessed portion 72, and can effectively reflect the incident light radiated to the dead zone 7.

The two end portions 61 of the sub-cell 6 shown in FIG. 3 to FIG. 5 are arranged opposite to each other along the first direction Y As an example, the plurality of sub-cells 6 include at least a first sub-cell and a second sub-cell. The body portion 71 of the dead zone 7 connects the end portion of the first sub-cell and the end portion of the second sub-cell. The recessed portion 72 of the dead zone 7 is formed by recessing the dead zone toward the substrate 50 relative to the main portion 71. The recessed portion 72 is disposed close to the end portion of the second sub-cell. The Y-direction shown in FIG. 3 represents the first direction. The first direction Y is perpendicular to the thickness direction X.

In some examples, a reflection portion 54 may be disposed in the recessed portion 72.

Due to the existence of the recessed portion of the dead zone, external moisture and oxygen can oxidize and corrode the sub-cell through the dead zone, especially the recessed portion, thereby deteriorating the performance of the solar cell and impairing the reliability and stability of the solar cell. In this embodiment of this application, a reflection portion 54 is disposed in the recessed portion 72. The reflection portion 54 plays an obstruction role to some extent and can reduce, to some extent, the risk that external moisture and oxygen intrude into the sub-cell 6 through the recessed portion 72, thereby improving the reliability and stability of the solar cell 5. In addition, the external incident light may be reflected by the reflection portion 54 located in the recessed portion 72, and further reflected to the sub-cell 6 by the packaging component 55, thereby improving the utilization rate of light and further improving the photovoltaic conversion efficiency.

In other examples, the reflection portion 54 may be disposed on a surface of the main portion 71 of the dead zone 7, the surface being oriented toward the packaging component 55. The reflection portion can reflect the incident light radiated to this portion, thereby improving the utilization rate of light.

In some other examples, the reflection portion 54 is disposed in the recessed portion 72, and the reflection portion 54 is disposed on a surface of the main portion 71 of the dead zone 7, the surface being oriented toward the packaging component 55, thereby preventing external moisture and oxygen from intruding into the sub-cell 6, and improving the utilization rate of light.

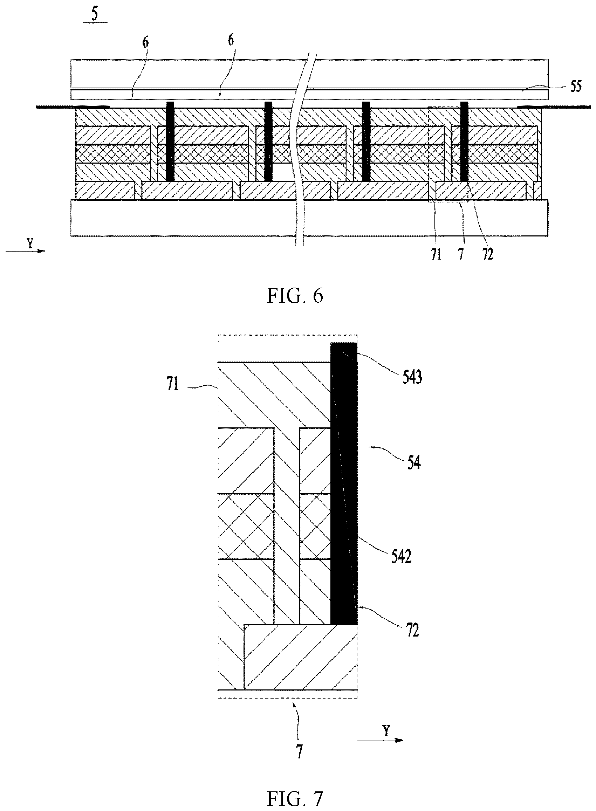

FIG. 6 is a schematic structural diagram of a solar cell according to some other embodiments of this application, and FIG. 7 is a close-up view of a dead zone and a reflection portion of the solar cell shown in FIG. 6.

As shown in FIG. 6 and FIG. 7, optionally, the reflection portion 54 includes a body portion 542 and an extension portion 543. The body portion 542 is disposed in the recessed portion 72. The extension portion 543 protrudes from a surface of the main portion 71, the surface being oriented toward the packaging component 55. The body portion 542 can obstruct external moisture and oxygen from intruding into the sub-cell 6. The extension portion 543 protrudes from the main portion 71, and can increase the light-receiving area, thereby further improving the utilization rate of light.

Still referring to FIG. 6 and FIG. 7, as an example, the extension portion 543 may be a cuboidal structure or the like. The surface of the cuboidal structure, which is oriented toward the packaging component 55, and the two surfaces opposite to each other along the first direction Y, and the like, can all reflect the incident light. Relatively many surfaces can reflect the incident light, thereby improving the utilization rate of light.

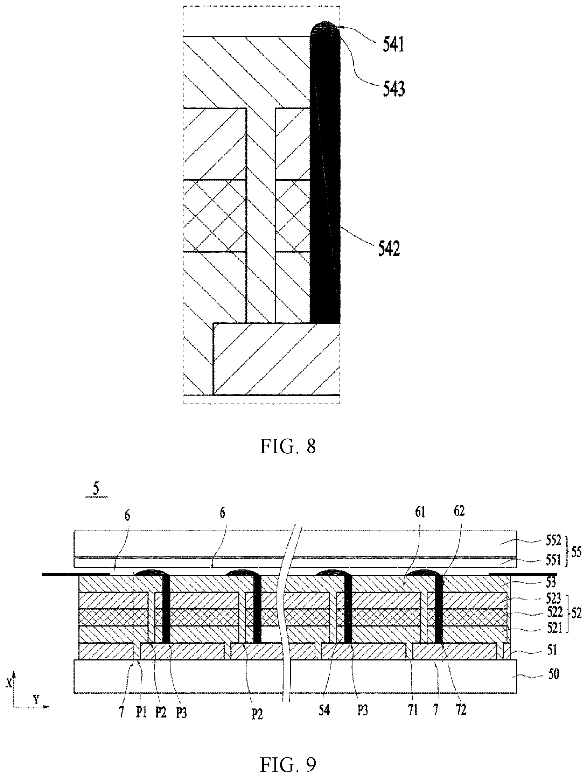

FIG. 8 is another close-up view of a dead zone and a reflection portion of the solar cell shown in FIG. 6.

As shown in FIG. 8, as another example, the extension portion 543 may be an arc structure. The arc structure includes a curved convex surface 541 protruding away from the dead zone 7. The curved convex surface 541 can increase light divergence rate, so that the incident light is reflected to the packaging component along different reflection paths, thereby reducing the amount of the incident light that is reflected back to the dead zone after being reflected by the packaging component.

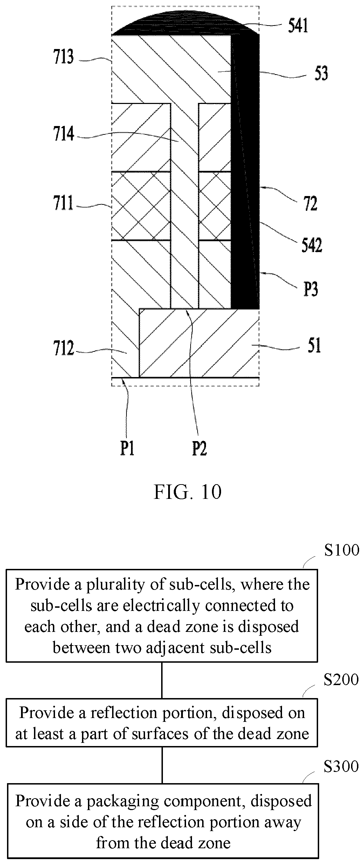

FIG. 9 is a schematic structural diagram of a solar cell according to still some other embodiments of this application, and FIG. 10 is a close-up view of a dead zone and a reflection portion of the solar cell shown in FIG. 9.

As shown in FIG. 9 and FIG. 10, optionally, a part of the extension portion 543 is located on the surface, oriented toward the packaging component 55, of the main portion 71. Apart of the extension portion 543 is located on the surface, oriented toward the packaging component 55, of the body portion 542, and another part of the extension portion is located on the surface, oriented toward the packaging component 55, of the main portion 71, so that the light receiving area is further increased, thereby further improving the utilization rate of light.

Still referring to FIG. 9 and FIG. 10, the solar cell 5 in this embodiment of this application includes a first electrode layer 51, a photovoltaic conversion component 52, and a second electrode layer 53 that are stacked sequentially along the thickness direction X of the solar cell. The first electrode layer 51 and the second electrode layer 53 are of opposite polarities. The first electrode layer 51 and the second electrode layer 53 are configured to lead out the electric current. As an example, the first electrode layer 51 is disposed close to the substrate 50, and the second electrode layer 53 is disposed on a side of the photovoltaic conversion component 52, the side being oriented back from the substrate 50. The photovoltaic conversion component 52 is configured to convert the incident light from optical energy to electrical energy, generate electrons and holes in the photovoltaic conversion component 52, and transport the electrons and holes to the electrode layer separately.

The following is an exemplary manufacturing method of a solar cell 5 in which a plurality of sub-cells 6 are connected in series. The manufacturing method includes the following steps: providing a substrate 50; forming a first electrode layer 51 on the substrate 50, and performing a first etch on the first electrode layer 51 so that a plurality of first hollowed portions P1 running through the first electrode layer 51 are formed in the first electrode layer 51; forming a photovoltaic converter component 52 on a side of the first electrode layer 51, the side being oriented back from the substrate 50; performing a second etch on the photovoltaic converter component 52 so that a plurality of second hollowed portions P2 are formed in the photovoltaic conversion component 52; forming a second electrode layer 53 on a side of the photovoltaic conversion component 52, the side being oriented back from the substrate 50, where the second electrode layer 53 extends into the second hollowed portions P2; and performing a third etch on the second electrode layer 53 and the photovoltaic conversion component 52 so that a plurality of third hollowed portions P3 are formed in the second electrode layer 53 and the photovoltaic conversion component 52, thereby obtaining a plurality of sub-cells 6 connected in series.

In some embodiments, the photovoltaic conversion component 52 includes a photovoltaic conversion layer 522. The photovoltaic conversion layer 522 may be a perovskite photovoltaic conversion layer, a cadmium zinc telluride photovoltaic conversion layer, a copper indium gallium selenide photovoltaic conversion layer, a copper indium selenide photovoltaic conversion layer, or a copper indium gallium sulfur photovoltaic conversion layer.

To improve the transport efficiency of electrons, optionally, the photovoltaic conversion component 52 may further include an electron transport layer 523 configured to transport electrons, obstruct transport of holes, reduce recombination of electrons and holes, and improve the photovoltaic conversion efficiency.

To improve the transport efficiency of holes, optionally, the photovoltaic conversion component 52 may further include a hole transport layer 521 configured to transport holes, obstruct transport of electrons, reduce recombination of holes and electrons, and improve the photovoltaic conversion efficiency.

The following describes a structure of the solar cell 5 in detail by using an example in which the solar cell 5 is a perovskite solar cell. The perovskite solar cell may be of a regular configuration (n-i-p structure) or an inverted configuration (p-i-n structure).

The regular perovskite solar cell includes a transparent conductive electrode, an electron transport layer, a perovskite photovoltaic conversion layer, a hole transport layer, and a metal electrode that are stacked sequentially along the thickness direction of the solar cell. As an example, the transparent conductive electrode includes an indium tin oxide ITO or a fluorine-doped tin oxide FTO. The electron transport layer includes a titanium oxide layer or the like. The hole transport layer includes 2,2',7,7'-tetrakis[N,N-bis(4-methoxyphenyl)amino]-9,9'-spirobifluorene (Spiro-OMeTAD) and the like. The metal electrode includes a gold layer, a silver layer, or an aluminum layer.

The inverted perovskite solar cell includes a transparent conductive electrode, a hole transport layer, a perovskite photovoltaic conversion layer, an electron transport layer, and a metal electrode that are stacked sequentially along the thickness direction of the solar cell. As an example, the transparent conductive electrode includes an indium tin oxide ITO layer or a fluorine-doped tin oxide FTO layer. The hole transport layer includes a PEDOT: PSS layer, where PEDOT denotes a polymer of EDOT (3,4-ethylenedioxythiophene) monomers, and PSS denotes polystyrene sulfonate (PSS). The electron transport layer includes a fullerene derivative ([6,6]-phenyl-C61-butyric acid methyl ester) layer, or a C60 layer. The metal electrode includes a gold layer, a silver layer, or an aluminum layer. The preparation process of the solar cell of this structure is relatively simple. The examples shown in FIG. 9 and FIG. 10 are an inverted perovskite solar cell.

As an example of the preparation process of an inverted perovskite solar cell, the specific preparation process includes:
providing a substrate;
forming a transparent conductive electrode on a surface of the substrate by magnetron sputtering or by a chemical means;
performing a first etch by using laser etching, masking, or exposure so that a plurality of first hollowed portions that run through the transparent conductive electrode are formed in the transparent conductive electrode;
forming a hole transport layer on a surface, oriented back from the substrate, of the transparent conductive electrode by magnetron sputtering, chemical deposition, atomic layer deposition ALD, or coating;
forming a perovskite photovoltaic conversion layer on a surface, oriented back from the substrate, of the hole transport layer by coating, spraying, spin-coating, evaporation, or chemical deposition;
forming an electron transport layer on a surface, oriented back from the substrate, of the perovskite photovoltaic conversion layer by magnetron sputtering, chemical deposition, atomic layer deposition ALD, or coating;
performing a second etch by laser etching, masking, or exposure, so as to form a plurality of second hollowed portions in the hole transport layer, the perovskite photovoltaic conversion layer, and the electron transport layer separately;
forming a metal electrode on a surface, oriented back from the substrate, of the electron transport layer by magnetron sputtering, chemical deposition, atomic layer deposition ALD, or coating; and
performing a third etch by laser etching, masking, or exposure, so as to form third hollowed portions in the metal electrode, the hole transport layer, the perovskite photovoltaic conversion layer, and the electron transport layer separately.

On the basis of the above steps, a positive output electrode and a negative output electrode may be welded by means of conductive tape bonding, ultrasonic welding, laser welding, or a by using a soldering flux, so as to form external output electrodes. Subsequently, the surface, oriented back from the substrate, of the metal electrode is irradiated to form an adhesive film. A cover glass is disposed on a side, oriented back from the substrate, of the adhesive film. Finally, the entirety is fed into a laminator or an autoclave for being press-fitted and packaged.

Still referring to FIG. 9 and FIG. 10, in an embodiment of this application, of the first electrode layer 51, the photovoltaic conversion component 52, and the second electrode layer 53, a part is located in the region of the plurality of sub-cells 6, and another part is located in the dead zones 7. The dead zone 7 includes a region located from a first hollowed portion P1 to a third hollowed portion P3. The third hollowed portion P3 may be a hollowed structure, and the reflection portion 54 is disposed in the hollowed structure.

In some embodiments, the photovoltaic conversion component 52 located in the dead zone 7 includes a first photovoltaic portion 711 and a second photovoltaic portion 712. The first photovoltaic portion 711 is located on a surface of the first electrode layer 51. The second photovoltaic portion 712 connects the first photovoltaic portion 711 and the first electrode layer 51. The second electrode layer 53 located in the dead zone 7 includes a first electrode portion 713 and a second electrode portion 714. The first electrode portion 713 is located on a surface of the first photovoltaic portion 711, the surface being oriented back from the first electrode layer 51. The second electrode portion 714 connects the first electrode portion 713 and the first electrode layer 51 located in the dead zone 7. The recessed portion 72 runs through at least the first electrode portion 713. The second electrode portion 714 is connected to the first electrode layer 51 to implement series connection between adjacent sub-cells 6. This form of structure simplifies the preparation process and is cost-effective. In this embodiment of this application, the first electrode layer 51, the photovoltaic conversion component 52, and the second electrode layer 53 located in the dead zone 7 are integral part of the main portion 71 of the dead zone 7.

The second photovoltaic portion 712 is located in the first hollowed portion P1. The second electrode portion 714 is located in the second hollowed portion P2. The recessed portion 72 corresponds to the third hollowed portion P3. By disposing the reflection portion 54 on at least a part of the surfaces of the dead zone 7, the process window of the dead zone 7 can be broadened to facilitate large-scale and large-size production applications. As an example, the arrangement of the reflection portion reduces the requirement on the dimensions of at least one of the first hollowed portion P1, the second hollowed portion P2, and the third hollowed portion P3. The line width of the first hollowed portion P1 is 5 µm to 100 µm, the line width of the second hollowed portion P2 is 10 µm to 120 µm, and the line width of the third hollowed portion P3 is 5 µm to 100 µm. An adjacent edge distance from the first hollowed portion P1 to the second hollowed portion P2 is 10 µm to 200 µm, and an adjacent edge distance from the second hollowed portion P2 to the third hollowed portion P3 is 10 µm to 200 µm. The width of the dead zone 7 is 40 µm to 720 µm. By setting the line width of and the spacing between the hollowed portions to a value close to the upper limit, the process window can be broadened significantly, and the precision requirement and cost of the processing equipment can be reduced.

An embodiment of this application further provides a solar cell manufacturing method.

FIG. 11 is a schematic flowchart of a solar cell manufacturing method according to some embodiments of this application. As shown in FIG. 11, the manufacturing method according to some embodiments of this application includes:
S 100: Providing a plurality of sub-cells, where the sub-cells are electrically connected to each other, and a dead zone is disposed between two adjacent sub-cells;
The specific etching methods for segmenting the solar cell into sub-cells and electrically connecting the sub-cells (for example, in series) are the same as those described in the preceding embodiment, and are omitted here.

S200: Providing a reflection portion, disposed on at least a part of surfaces of the dead zone; and
In this step, the reflection portion may be formed on at least a part of the surfaces of the dead zone by filling, printing, spraying, local region curing, physical deposition, or other means.

S300: Providing a packaging component, disposed on a side of the reflection portion away from the dead zone.

The manufacturing method according to this embodiment of this application is applicable to manufacturing the solar cell disclosed in the preceding embodiment. In the solar cell prepared by this manufacturing method, a reflection portion is disposed on at least a part of the surfaces of the dead zone, thereby improving the photovoltaic conversion efficiency of the solar cell, and improving the reliability and stability of the solar cell.

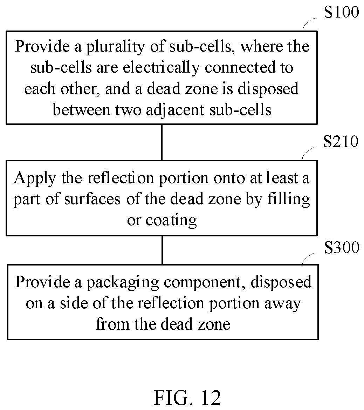

FIG. 12 is a schematic flowchart of a solar cell manufacturing method according to some other embodiments of this application. As shown in FIG. 12, in some embodiments, step S200 includes:
S210: Applying the reflection portion onto at least a part of surfaces of the dead zone by filling or coating. The manufacturing method is relatively simple, and improves the light utilization rate of the prepared solar cell.

Although this application has been described with reference to exemplary embodiments, various improvements may be made to the embodiments without departing from the scope of this application, and the components of this application may be replaced with equivalents. Particularly, to the extent that no structural conflict exists, various technical features mentioned in various embodiments may be combined in any manner. This application is not limited to the specific embodiments disclosed herein, but includes all technical solutions falling within the scope of the claims.

## Claims

1. A solar cell, comprising:
a plurality of sub-cells, wherein the plurality of sub-cells are electrically connected to each other;
a dead zone, disposed between two adjacent sub-cells;
a reflection portion, disposed on at least a part of surfaces of the dead zone, and configured to reflect incident light radiated on the dead zone;
a packaging component, disposed on a side of the reflection portion away from the dead zone, and configured to reflect the incident light, which is reflected by the reflection portion, to a surface of the sub-cell to convert the incident light into electrical energy.

2. The solar cell according to claim 1, wherein the reflection portion covers all surfaces, oriented toward the packaging component, of the dead zone.

3. The solar cell according to claim 1 or 2, wherein the reflection portion comprises a curved convex surface protruding away from the dead zone.

4. The solar cell according to any one of claims 1 to 3, wherein
the plurality of sub-cells each comprise two end portions disposed opposite to each other; and
the dead zone comprises a main portion and a recessed portion, the main portion connects the end portions of the two adjacent sub-cells, the recessed portion is formed by recessing the dead zone relative to the main portion, and the reflection portion is disposed on the main portion and/or the recessed portion.

5. The solar cell according to claim 4, wherein
the reflection portion comprises a body portion and an extension portion, the body portion is disposed in the recessed portion, and the extension portion protrudes from a surface of the main portion, the surface being oriented toward the packaging component.

6. The solar cell according to claim 5, wherein
a part of the extension portion is located on the surface of the main portion, the surface being oriented toward the packaging component.

7. The solar cell according to claim 4, wherein the main portion comprises:
a first electrode layer;
a photovoltaic conversion component, comprising a first photovoltaic portion and a second photovoltaic portion, wherein the first photovoltaic portion is located on a surface of the first electrode layer, and the second photovoltaic portion connects the first photovoltaic portion and the first electrode layer; and
a second electrode layer, comprising a first electrode portion and a second electrode portion, wherein the first electrode portion is located on a surface of the first photovoltaic portion, the surface being oriented back from the first electrode layer, the second electrode portion connects the first electrode portion and the first electrode layer, and the recessed portion runs through at least the first electrode portion.

8. The solar cell according to claim 7, wherein
the photovoltaic conversion component comprises a photovoltaic conversion layer, and the photovoltaic conversion layer is located at least between the first electrode layer and the second electrode layer;
the photovoltaic conversion component further comprises an electron transport layer, and the electron transport layer is located between the photovoltaic conversion layer and the second electrode layer; and/or
the photovoltaic conversion component further comprises a hole transport layer, and the hole transport layer is located between the photovoltaic conversion layer and the first electrode layer.

9. A photovoltaic module, comprising the solar cell according to any one of claims 1 to 8.

10. An electrical device, comprising the photovoltaic module according to claim 9.

11. A solar cell manufacturing method, comprising:
providing a plurality of sub-cells, wherein the sub-cells are electrically connected to each other, and a dead zone is disposed between two adjacent sub-cells;
providing a reflection portion, disposed on at least a part of surfaces of the dead zone; and
providing a packaging component, disposed on a side of the reflection portion away from the dead zone.

12. The manufacturing method according to claim 11, wherein providing a reflection portion disposed on at least a part of surfaces of the dead zone comprises:
applying the reflection portion onto at least a part of surfaces of the dead zone by filling or coating.
